(19) **Europäisches Patentamt / European Patent Office / Office européen des brevets**

(11) **EP 1 483 627 B1**

(12) **EUROPEAN PATENT SPECIFICATION**

(45) Date of publication and mention
of the grant of the patent:
**03.09.2008 Bulletin 2008/36**

(51) Int Cl.:
***G03F 9/00*** (2006.01)

(21) Application number: **03710285.2**

(86) International application number:
**PCT/JP2003/002752**

(22) Date of filing: **07.03.2003**

(87) International publication number:
**WO 2003/077030 (18.09.2003 Gazette 2003/38)**

(54) **SCANNING EXPOSURE APPARATUS AND DEVICE MANUFACTURING METHOD USING THE SAME**

ABTASTBELICHTUNGSAPPARAT UND VERFAHREN ZUR HERSTELLUNG EINER VORRICHTUNG UNTER VERWENDUNG DESSELBEN

APPAREIL D'EXPOSITION PAR BALAYAGE ET PROCEDE DE FABRICATION DE DISPOSITIFS L'UTILISANT

(84) Designated Contracting States:
**DE IT NL**

(30) Priority: **08.03.2002 JP 2002063705**

(43) Date of publication of application:
**08.12.2004 Bulletin 2004/50**

(73) Proprietor: **CANON KABUSHIKI KAISHA**
**Ohta-ku**
**Tokyo 146-8501 (JP)**

(72) Inventors:
- **MAEDA, Kohei**
  **Tochigi 320-0003 (JP)**
- **MIURA, Seiya**
  **Tochigi 321-0943 (JP)**

(74) Representative: **TBK-Patent**
**Bavariaring 4-6**
**80336 München (DE)**

(56) References cited:
**WO-A-02/43123**      **JP-A- 11 045 846**
**US-A- 5 602 399**      **US-A1- 2001 028 446**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

[TECHNICAL FIELD]

This invention relates generally to a projection exposure method and a projection exposure apparatus to be used for exposing a substrate such as a wafer to a reticle pattern, in a lithographic process for manufacture of semiconductor devices or liquid crystal display devices, for example.

[BACKGROUND ART]

In addition to step-and-repeat type exposure apparatuses such as a stepper, recently scan type projection exposure apparatuses (scanning exposure apparatuses) such as a step-and-scan type exposure apparatus, have been used for manufacture of semiconductor devices or the like. A projection optical system used in such projection exposure apparatuses is required to provide a resolving power close to its limit. In consideration of it, a mechanism is used to measure factors being influential to the resolving power (atmospheric pressure, ambience temperature, and the like) and to correct the imaging characteristic in accordance with the measurement result. Further, since the numerical aperture of the projection optical system is made large so as to attain a higher resolving power, the depth of focus becomes very shallow as a consequence of it. In consideration of it, an oblique incidence type focal point position detecting system is used to measure the focus position (position in the optical axis direction of the projection optical system) of a wafer surface which is variable with the surface irregularity. Also, an autofocusing mechanism is used to adjust the wafer surface position into registration with the image plane of the projection optical system, in accordance with the focus position measurement.

Additionally, in recent years, an imaging error due to deformation of a reticle (as a mask) can not be neglected. More specifically, if, for example, the pattern surface of a reticle is deflected or flexed uniformly toward the projection optical system, the imaging position shifts in the same direction as the shift of the reticle pattern surface. As a result, if the wafer position is the same, there occurs a defocus. Further, if the reticle pattern surface is deformed, the pattern position inside the pattern surface (position in a direction along the plane which is perpendicular to the optical axis of the projection optical system) may change. Such lateral shift of the pattern would cause a distortion error.

Factors for causing such reticle deformation may be categorized as (a) weight deformation, (b) flatness of reticle pattern surface, and (c) deformation due to the flatness of a contact surface when a reticle is attracted and held by a reticle holder (this includes deformation caused by sandwiching a foreign particle thereat). The magnitude of deformation caused by such factors may be about 0.5 micron, but if such a reticle is projected by a projection optical system having a projection magnification of 1:4, at the imaging position there would occur a positional deviation of 30 nm with respect to the reticle deformation direction. This is so large and it can not be neglected. In consideration of it, deformation of the reticle pattern surface may be measured, and the imaging performance may be compensated for in accordance with the measurement result. However, the reticle measurement must be done very precisely. It would be necessary to measure the amount of deformation of the reticle pattern surface with a measurement precision of about 0.1 micron. Further, since the reticle deformation differs in every reticle and in every reticle holder of exposure apparatuses, in order to accomplish exact measurement of the reticle deformation, it would be necessary to carry out the measurement while a reticle is being actually attracted to and held by a reticle holder of a projection exposure apparatus.

As discussed above, in order to attain a higher imaging performance in a projection exposure apparatus, it is desirable to perform measurement of the pattern surface shape not only at the wafer side but also at the reticle side. To this end, for measurement of the reticle surface shape, a position sensor similar to an oblique incidence type autofocusing sensor for detecting the focus position of a wafer, may be provided also at the reticle stage side.

In such occasion, since the pattern surface of the reticle is formed at the bottom face thereof, i.e. at the projection optical system side of the reticle. Therefore, the detection light for detecting the pattern surface shape must be obliquely projected thereto, from the bottom side of the reticle. However, in that occasion, since this detection light impinges directly upon the pattern surface of the reticle, the detection light would be influenced by a difference in reflectivity of the pattern (i.e. reflectivity difference between chromium and glass). Therefore, accurate detection of the surface shape would be difficult to accomplish.

Moreover, in some cases, a dust-protection film (pellicle) is attached to a reticle through a metal frame, for protection of the reticle pattern surface against adhesion of foreign particles. In such occasion, the obliquely projected light may be blocked by the metal frame and, to prevent it, the detection light should not be projected to the reticle pattern surface at a very shallow angle (large incidence angle). Further, because of the presence of the metal frame, there is a limitation in regard to the position detectable region for the pattern surface, depending on the incidence direction of the detection light of oblique incidence type position sensor. It is therefore difficult to perform direct measurement of the surface shape, over the whole shot region on the pattern surface.

JP 11 045846 A shows a surface shape detecting system 30 for detecting the surface shape of a reticle R. However, no inclination of the light used for such a detection is derivable from this document.

US-A-2001/0028446 discloses a scanning exposure apparatus according to the preamble of claim 1.

[DISCLOSURE OF THE INVENTION]

It is the object of the present invention, to provide a scanning exposure apparatus and a device manufacturing method using such a scanning exposure apparatus by which the precision of the direct measurement of the reticle surface shape over the whole shot region on the pattern surface of the reticle can be increased.

This object is solved by the scanning exposure apparatus according to claim 1. And, this object is solved by a device manufacturing method according to claim 6.

Further developments are set out in the dependent claims.

These and other objects, features and advantages of the present invention will become more apparent upon a consideration of the following description of the preferred embodiments of the present invention taken in conjunction with the accompanying drawings.

BREIF DESCRIPTION OF THE DRAWINGS

Figure 1 is a schematic view of a main structure of a projection exposure apparatus according to an embodiment of the present invention.

Figure 2 is a schematic view for explaining reticle deformation and the function of a reticle surface position detecting system.

Figures 3A - 3C illustrate waveform signals of detection light upon a CCD sensor, wherein Figure 3A shows a reference state, Figure 3B shows a state in which there is Z displacement but the signal is not influenced by a reticle pattern, and Figure 3C shows a state in which there is Z displacement and the signal is influenced by the reticle pattern.

Figure 4 is a schematic view for explaining a change in gravity center of a detection light waveform due to a difference in reflectivity of a pattern being formed on the reticle surface.

Figure 5 is a graph for explaining the relationship among the incidence angle of detection light, reflectivity ratio of the pattern ("reflectivity of chromium" vs. "reflectivity of glass"), and a measurement error attributable to the pattern.

Figure 6 illustrates a detection sectional plane and a detection plane, for explaining how the detection region is narrowed by increases $(\theta_{12}<\theta_{11}<\theta_{10})$ in incidence angle of the detection light due to the presence of a metal frame.

Figure 7 is a schematic view for explaining differences in regard to the detection region where the detection light is incident from a direction orthogonal to the scan direction, at different incidence angles $\theta_{12}$, $\theta_{11}$, and $\theta_{10}$ $(\theta_{12}<\theta_{11}<\theta_{10})$.

Figure 8 is a schematic view for explaining a difference in regard to the detection region, where the detection light is obliquely incident from a direction having an angle ø with respect to the scan direction.

Figure 9 is a schematic view for explaining, when detection light is obliquely incident from a direction having an angle ø with respect to the scan direction, a distance "a" from an inside frame of a metal frame member to an edge of a largest detecting region with respect to a non-scan direction, as well as a distance "b" from the inner frame of the metal frame member to an edge of a largest detecting region.

Figures 10A - 10C are graphs, respectively, for explaining the relationship between an estimated idealistic reticle deflected surface (with a deflection amount $R_{true-value}$) and an approximated reticle deflected surface (with a deflection amount $R_{measurement}$), obtainable by approximating measurement of the reticle surface made with respect to three points (or five points), wherein Figure 10A is a case where the number of detection points is three, Figure 10B is a case where the detection span is enlarged, and Figure 10C is a case where the number of detection points is five.

Figure 11 is a graph for explaining the relationship between (i) a deflection range difference $(R_{measurement}$ minus $R_{true-value})$ between the approximation-measured surface where the reticle surface shape is measured by approximation, and an actual reticle surface, and (ii) the detectable region (vs. shot region).

Figure 12 is a schematic view for explaining a detection process in which detection light is obliquely incident along an incidence direction ø to perform the measurement of the reticle surface.

Figure 13 is a schematic view for explaining differences in regard to the detection region where the detection light is obliquely incident with incidence angles $\theta_{12}$, $\theta_{11}$, and $\theta_{10}$ $(\theta_{12}<\theta_{11}<\theta_{10})$ and in incidence direction of 45 deg. with respect to the scan direction.

Figure 14 is a graph for explaining an incidence angle range and an incidence direction range where a measurement error of a reticle pattern approximated surface is 0.1 micron or less.

[BEST MODE FOR PRACTICING THE INVENTION]

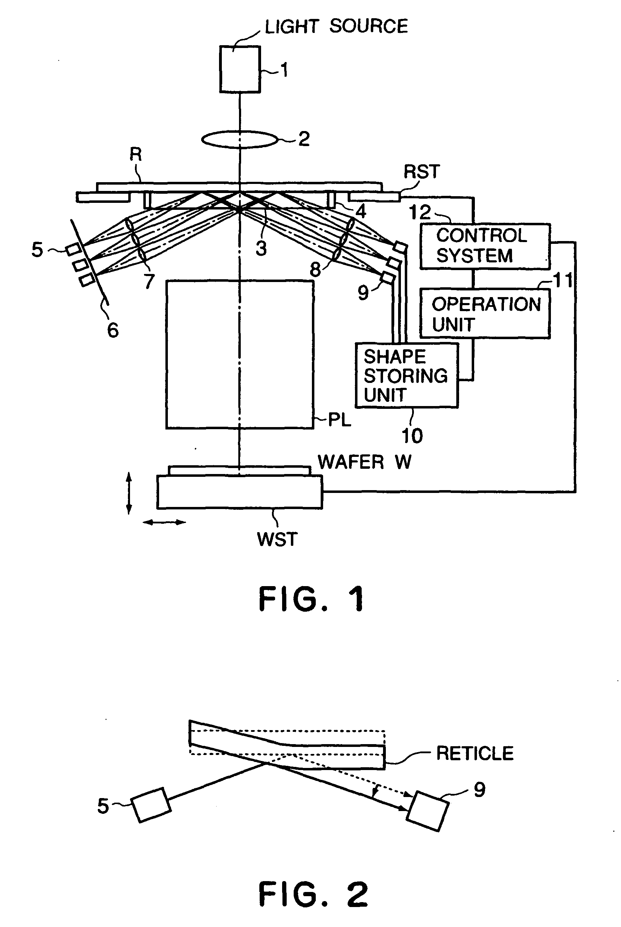

An embodiment of the present invention will now be described with reference to the attached drawings. In this embodiment, the invention is applied to an exposure process using a step-and-scan (scan type) projection exposure apparatus. Figure 1 illustrates a main portion of the projection exposure apparatus. In the drawing, a reticle R is held by a reticle holder, through vacuum attraction, with a pattern bearing surface thereof facing down. The reticle holder is scanningly movable in a direction perpendicular to the sheet of the drawing. Disposed above the reticle is a light source 1 for outputting light to be used for exposure. Disposed between the light source 1 and the reticle R is an illumination optical system 2. At a side of the reticle R remote from the illumination optical system 2, there are a projection optical system PL and a wafer W. The wafer W is mounted on a wafer stage WST which is movable in X, Y and Z directions and which is tilt-adjustable, for enabling wafer whole surface exposure, scan exposure and focus correction. The structure shown Figure 1 includes a reticle R, a projection optical system PL, a wafer W, a reticle stage RST, a wafer stage WST, a dust adhesion preventing film (pellicle) 3, a metal frame 4, a detection light source 5, a slit 6 for projection mark, light projecting lenses 7, light receiving lenses 8, detectors 9, a shape storing unit 10, an operation unit 11, and a control system 12.

The projection exposure operation of this embodiment is similar to that of an ordinary projection exposure apparatus. Namely, exposure light emitted from the light source 1 is projected by the illumination optical system 2 onto the reticle R. Then, with the exposure light, an image of a pattern formed on the reticle is projected onto the wafer W through the projection optical system PL. The reticle R and the wafer W are relatively scanningly moved in a direction orthogonal to the sheet of the drawing, by which one-shot exposure is carried out.

In this embodiment, as shown in Figure 1, a reticle surface position detecting system is provided below the reticle holder. This reticle surface position detecting system has a structure and a function similar to those of an oblique incidence type focus sensor for bringing the wafer surface, to be exposed, into registration with the imaging plane of the projection optical system. Specifically, it comprises a light projecting portion and a light detecting portion. More particularly, it functions to project detection light from the light projecting portion onto the pattern bearing surface of the reticle, and also to detect reflection light therefrom by means of the light detecting portion, thereby to detect the surface position of the reticle. The light projecting portion comprises, as main components, a light source 5 such as a light emitting diode, for example, a slit 6 for projection marks, and light projecting lenses 7. The light detecting portion comprises, as main components, light receiving lenses 8 and detectors 9 such as CCD sensors, for example. Here, with respect to the reticle scan direction (direction perpendicular to the sheet of the drawing) and also to a direction orthogonal to the reticle scan direction (i.e. lateral direction along the sheet of the drawing), a plurality of detection systems are provided. By scanning the reticle in this structure, the surface position can be measured at different points (detection points) on the reticle surface. From the results of measurements, the surface shape of the reticle surface can be measured.

The surface shape as measured by this surface position measuring system is stored by the shape storing unit 10, and then an approximation surface regarding the reticle whole surface is calculated by the operation unit 11.

Here, as regards the method of correcting deflection or flexure of the reticle pattern surface as measured in accordance with the procedure described above, the following methods are available.

(1) To physically correct the flexure:

A piezoelectric device or any other actuator may be used to apply a force to the reticle in a direction correcting the flexure, thereby to physically correct it. Here, the actuator is not limited to a piezoelectric device. A bolt and a nut or the like may be used to apply a force to the reticle. Alternatively, a pressure-controllable closed space may be provided at an upper side and/or lower side of the reticle and, by controlling the pressure inside this space, the flexure of the reticle may be corrected.

(2) To optically correct the flexure:

Any flexure of the reticle whole surface in the scan direction can be corrected optically by moving the wafer stage in the scan direction while moving the same in the optical axis direction (Z direction) of the projection optical system. As regards flexure in the scan direction, the scanning exposure may be done while well keeping the conjugate relationship between the reticle pattern surface and the wafer surface by moving the wafer stage upwardly and downwardly. As regards flexure in a direction orthogonal to the scan direction, an optical element or elements inside the projection optical system may be moved to produce a field curvature, such that the scan exposure may be done while making adjustment that the reticle pattern surface being deflected is well imaged upon the wafer surface. It will be the best if the scan exposure can be carried out while the adjustment of the wafer stage as well as the adjustment of the projection optical system are performed in real time. If it is difficult to do both of them in real time, the reticle may be divided into plural zones with respect to the scan direction and, in relation to each zone, the wafer stage may be driven in the optical axis direction (Z direction). This makes the control very simple. Further, as regards the reticle flexure in a direction orthogonal to the scan direction, the following procedure may be done. Usually, if a deflected reticle is projected by a projection optical system, the image plane would be curved. In consideration of it, an optical element (which may be a lens or a mirror) of the projection optical system is moved along the optical axis direction, thereby to change the field curvature of the projection optical system, such that a curvature of field attributable to the flexure of the reticle and the field curvature changed by shifting the optical element of the projection optical system can be cancelled with each other. With this setting, the flexure of the reticle can be corrected optically.

Furthermore, if it is possible to sufficiently reduce the influence of curvature of the reticle by moving the optical element of the projection optical system, flexure in the scan direction as well as flexure in a direction orthogonal to the scan direction can be corrected optically by means of moving the optical element.

(3) To replace the reticle by another:

The system has the function that, if it is discriminated from the results of reticle surface shape measurement that the curvature of the image plane due to the flexure of the reticle can not be reduced to a tolerable range and that the exposure imaging performance would be deteriorated thereby, a signal is transmitted to the reticle stage RST through the control system 12 to urge replacement or resetting of the reticle.

Next, the embodiment of the present invention will be described in greater detail.

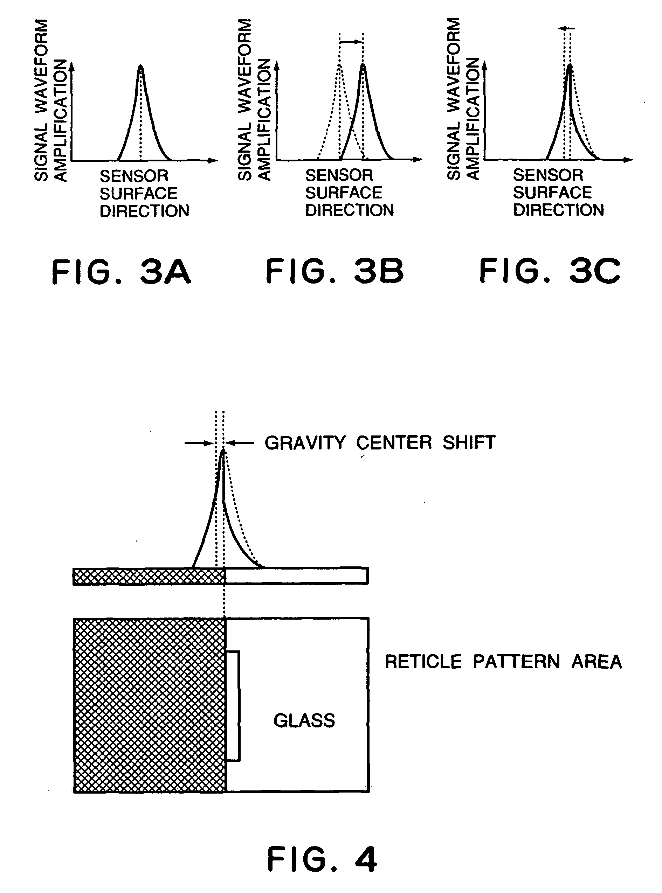

The operation of the above-described reticle surface position detecting system will be explained with reference to Figures 2 and 3. The light emitted from the light source 5 passes through the projection mark slit 6, and it is collected by the projecting lens 7 at a position adjacent the reticle pattern surface. The light reflected by the reticle pattern surface is collected again by the light receiving lens 8 upon the detector 9. The position adjacent the reticle surface where the light is collected is taken as a detection point, and there are plural detection points set along a direction orthogonal to the scan direction. In such state, the reticle is scanningly moved and the surface position detection at each detection point is carried out at a predetermined pitch. On the basis of the results of measurement, the surface shape of the reticle surface is measured. The surface shape measurement method will be explained in more detail. In the surface shape detecting system, as shown in Figure 2, detection light from the light projecting system 5 is obliquely projected on the reticle surface, being depicted by a broken line, and light reflected thereby is incident on the light receiving unit 9. As such detection light is received by a CCD sensor or the like, a waveform such as shown in Figure 3A is detected. Taking the gravity center position of the waveform as the positional information, the position of the reticle surface at the corresponding detection point can be detected. If, for example, the reticle pattern surface is deflected such as depicted by a solid line in Figure 2, the detection light reflected by such reticle surface and entering the light detecting system would be shifted in a direction of a solid-line arrow in Figure 2. In that occasion, the detected waveform (gravity center position) to be detected by the detection system 5 and 9 would be shifted from its original waveform position in accordance with the pattern surface shape, such as shown in Figure 3B. From the amount of shift of the gravity center of each waveform, the position of the detection point with respect to Z direction (direction perpendicular to the reticle surface) can be detected.

If, however, for measurement of the reticle (pattern) surface, the detection light is projected to both of a portion where a pattern is formed (i.e. the portion coated with chromium) and a portion where no pattern is formed (i.e. a portion which is not coated with chromium and a glass material of reticle substrate is exposed), there is a possibility that the waveform produced by the detection light is distorted. If this occurs, it results in erroneous measurement of Z-axis position of the detection point (pattern surface). More specifically, in a case where the detection light impinges on a detection light irradiation region such as shown in Figure 4 (i.e. a quadrangular zone in the lower pat of Figure 4), if the detection light is obliquely incident on the reticle surface and it impinges on both of a portion having a pattern formed thereon and a portion having no pattern there, due to the difference in reflectivity of them (i.e. the reflectivity difference between chromium and glass), the waveform of detection light reflected by the reticle surface and received by the light receiving system may be distorted. Such distortion of the waveform would result in a change in gravity center of the waveform, and it leads to erroneous measurement of the position of the detection point on the reticle surface. Specifically, in a case where detection light impinges on the quadrangular zone shown in the lower part of Figure 4, since glass has a lower reflectivity as compared with chromium, the waveform of reflected light is deformed such as shown in the upper part of Figure 4, such that the gravity center of the waveform shifts leftwardly (from the position where the gravity center inherently exists). Thus, some measurement should be taken to avoid or reduce such erroneous measurement.

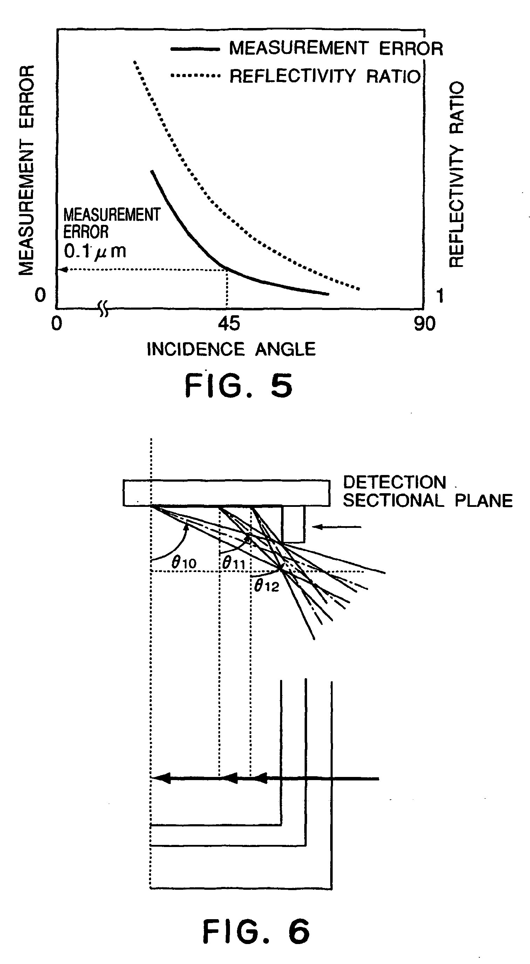

Figure 5 shows the relationship between the incidence angle of measurement light and the measurement error, and the reflectivity ratio of the pattern ("reflectivity of chromium" vs. "reflectivity of glass") which causes the error. It is seen from Figure 5 that, if the incidence angle becomes larger, the reflectivity ratio between chromium and glass becomes smaller and also the measurement error becomes smaller. For detection of the reticle pattern surface in the exposure apparatus, the measurement error in relation to each detection point should be kept at about 0.1 micron or less. In Figure 5, if the incidence angle of the detection light upon the pattern surface (i.e. the angle defined between the detection light and a normal to the pattern surface) is set to 45 deg. or more, the reflectivity ratio between chromium and glass can be kept sufficiently small such that the above-described performance requirement of measurement error not greater than 0.1 micron can be satisfied.

This embodiment uses a glass material. However, this glass material may be quartz, fluorine-doped quartz, or fluorite, for example. Also, a substrate of glass, quartz, fluorine-doped quartz or fluorite, being coated with an antireflection film or the like and then patterned with chromium may be used.

As discussed above, if the incidence angle is enlarged, the measurement precision is improved. Actually, however, the reticle to be used in an exposure apparatus may have a dust adhesion preventing film (pellicle) 3 attached thereto through a metal frame member 4 such as shown in Figure 1. In that occasion, the setting range for the incidence angle of detection light upon the pattern surface is restricted. Figure 6 shows an example wherein the detection light incident on the pattern surface is set in parallel to a direction orthogonal to the scan direction. In this case, three examples of $\theta_{10}$, $\theta_{11}$, $\theta_{12}$ are set in regard to the incidence angle of detection light upon the pattern surface. Taking into account that detection lights projected with these incidence angles have predetermined numerical apertures (NA), respectively, it is seen in Figure 6 that, the more the incidence angle is, the farther the position detectable region is remote from the pellicle.

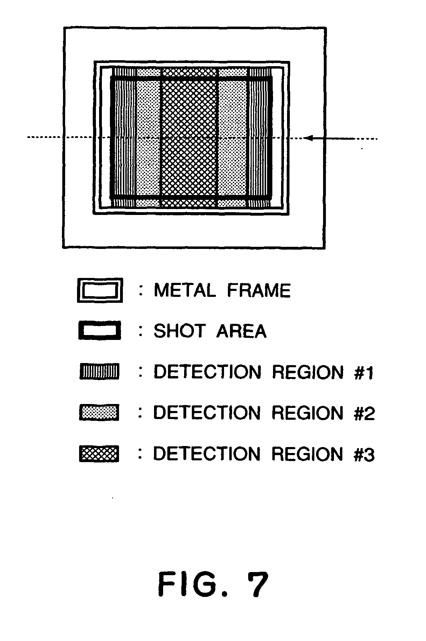

Figure 7 shows position detectable regions. More specifically, Figure 7 illustrates a pattern surface of a reticle as viewed in a direction perpendicular to the pattern surface. The metal frame refers to a frame member of the pellicle film. It is metal in this example, but the frame may be made of a material other than metal. The shot region refers to a region on the reticle in which a pattern to be projected is formed. Here, in the case where the incidence angle of detection light on the pattern surface is smallest (i.e. $\theta_{12}$), all of detection regions #1, #2 and #3 shown in Figure 7 are detectable regions. In the case where the incidence angle is second smallest (i.e. $\theta_{11}$), detection regions #2 and #3 are detectable regions. In the case where the incidence angle is largest (i.e. $\theta_{10}$), only detection region #3 is a detectable region.

In summary, it has been found that, as described above, unless the incidence angle of detection light upon the pattern surface is set to 45 deg or more, a desired measurement precision is not attainable. However, if the incidence angle is too large, the detectable range on the pattern surface becomes too narrow such that position detection over the whole shot region becomes unattainable.

In consideration of it, as a method of detecting the surface shape over the whole shot region without performing the position detection throughout the shot region, approximation measurement of the reticle surface shape in the shot region may be carried out on the basis of the results of measurements made with respect to plural detection points in the shot region.

Here, in this connection, description will be made on the relationship between the detection span (interval of detection points) and the number of detection points, which are important factors to be considered in regard to approximation measurement of the reticle pattern surface, and the precision of approximation for a deflected reticle surface.

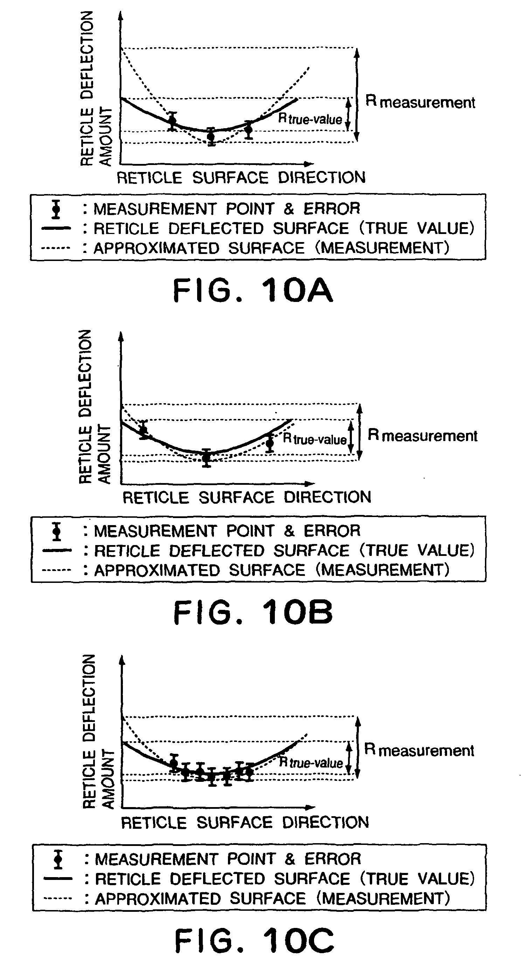

First, a two-dimensional reticle flexure surface such as depicted in Figure 10A is considered. In this example, three points are selected as position detection points and, on the basis of the results of detection at the three detection points, an approximated plane for the reticle pattern surface is produced. Here, the range for actual reticle deflection is denoted by $R_{true\text{-}value}$, while the range for approximated deflection surface is denoted by $R_{measurement}$ (in this example, the shot region is taken as a flexure evaluation region, and the range for a maximum value and a minimum value of the surface position in the shot region is defined as R). Figure 10B shows an example where the detection span of the three detection points is made larger as compared with the case of Figure 10A. It is seen from this that when a large detection span is chosen, as compared with a small detection span, the shape of the approximated surface of the reticle pattern surface is much closer to the actual reticle pattern surface shape. Namely, it has been found that, if the number of detection points is fixed, the larger the detection span is, the higher the approximation surface precision is.

Figure 10C shows an example wherein, although detection points are disposed substantially in the same region as the case of Figure 10A, the number of detection points is increased. Comparing the cases of Figure 10A and Figure 10C, it is seen that, if the number of detection points is enlarged (as compared with the case where the number is small), the shape of the approximated surface of the reticle pattern surface becomes closer to the actual reticle pattern surface shape. Namely, it has been found that, if the region to be detected (or detectable region) is the same, increasing the number of detection points is effective to obtain an approximated surface of the reticle pattern surface, having a shape closer to the actual pattern surface shape.

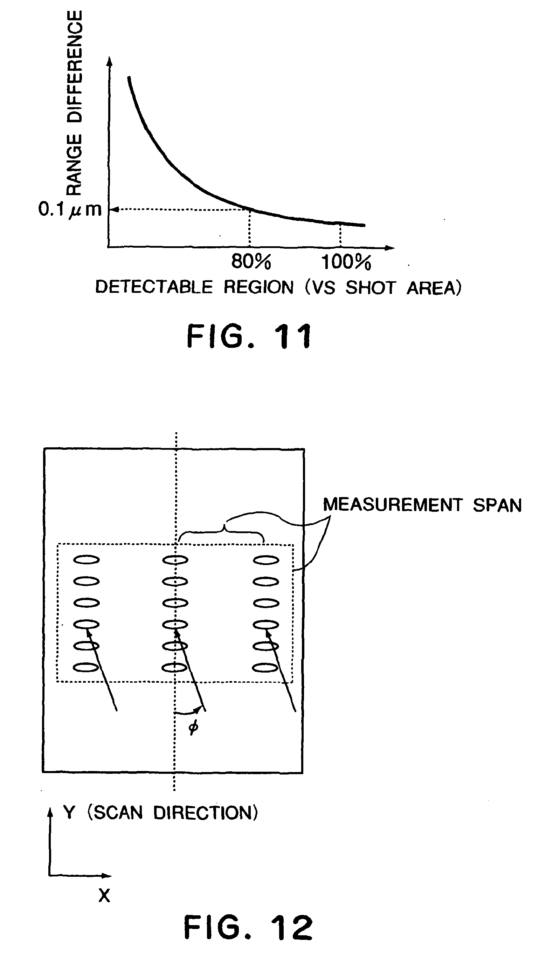

As described above, for good precision measurement of an actual reticle deflected surface, the approximation measurement should desirably be carried out while using an increased number of detection points or an enlarged detection span. In consideration of it, approximation measurement was carried out with a measurement error not greater than 0.1 micron at each detection point, while setting the detection points (three or more) and the detection span (although there was a limitation due to the incidence angle or incidence direction of detection light upon the pattern surface, a largest span that could be set within the shot region was chosen). Figure 11 illustrates the relationship between the detectable region (vs. shot region) and the above-described reticle flexure range difference (= $R_{measurement}$ minus $R_{true\text{-}value}$). It is seen from this that, as long as the detection region for approximation measurement of the reticle surface shape is 80% or more of the shot region, the range difference can be made to 0.1 micron or less.

An embodiment of effective reticle surface shape measuring system based on the results described above, will be explained below. In actual reticle surface shape detection, in some cases there may be a limitation with respect to a non-scan direction on the reticle surface, in relation to the assembly of the detecting system, such that many detection points can not be set. To the contrary, increasing the detection points along the scan direction is possible by reducing the measurement pitch. For this reason, as shown in Figure 12, the detection span in the non-scan direction in the detection region of the reticle surface may be enlarged (because the number of detection points is limited) whereas in the scan direction the number of detection points may be increased, thereby to assure high precision approximation of the surface shape of the reticle pattern surface. In that occasion, in respective detection directions (i.e. the scan direction and the direction orthogonal to the scan direction), by setting an appropriate incidence direction $\varnothing$ for the detection light (i.e. the angle to be defined between the scan direction and the detection light incident on the pattern, as viewed in a direction perpendicular to the reticle pattern surface), the region to be directly detected may be enlarged. This may increase the precision of an approximated surface of the pattern surface. In consideration of it, the relationship between the incidence direction $\varnothing$ and the detectable region has been investigated, as follows.

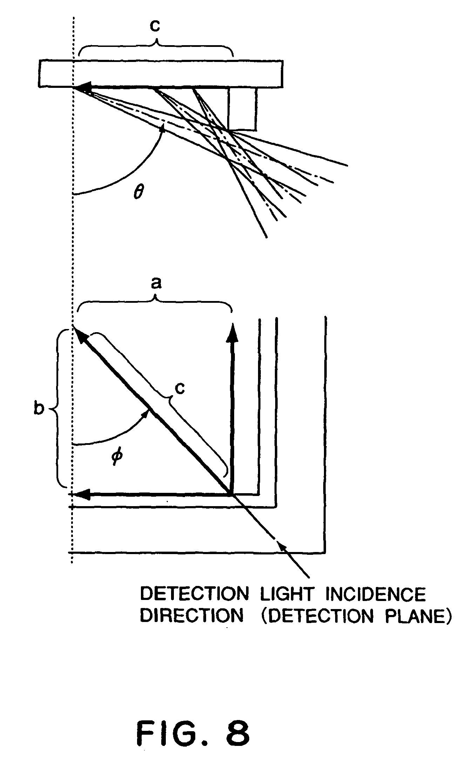

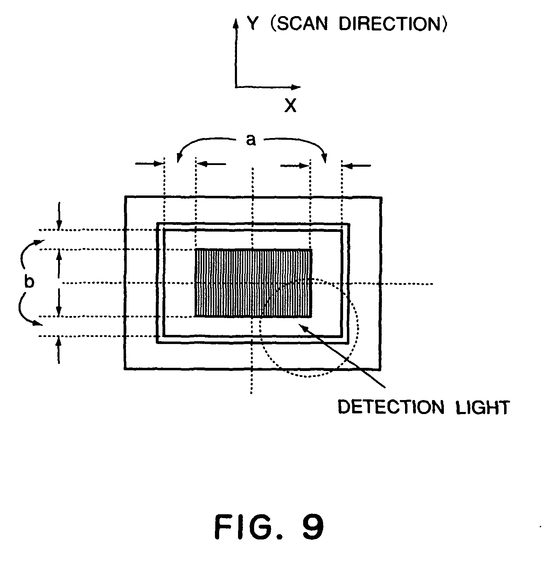

Figures 8 and 9 are views for explaining parameters as follows. As shown in Figures 8 and 9, where the incidence angle of detection light is $\theta$, the incidence direction is $\varnothing$, the numerical aperture is $\theta_{NA}$, the inside frame and the outside frame of the metal frame member are $P_{xin} x P_{yin}$ and $P_{xout} x P_{yout}$, the whole shot region is $P_{xshot} x P_{yshot}$, the metal frame height is h, and the largest detection region on the reticle pattern surface is XxY, then the distance "a" in X direction from the inside frame of the metal frame member to the edge of the largest detection region (detectable region) and the distance "b" in Y direction from the inside frame of the metal frame member to the edge of the largest detection region (detectable region), can be expressed as follows:

$$ a = h/tan(90-\theta-\theta_{NA})\sin\varnothing $$

$$ b = h/tan(90-\theta-\theta_{NA})\cos\varnothing $$

Also, X and Y in the largest detection region are expressed by:

$$ X = P_{xin}-2xa $$

$$ Y = P_{yin}-2xb $$

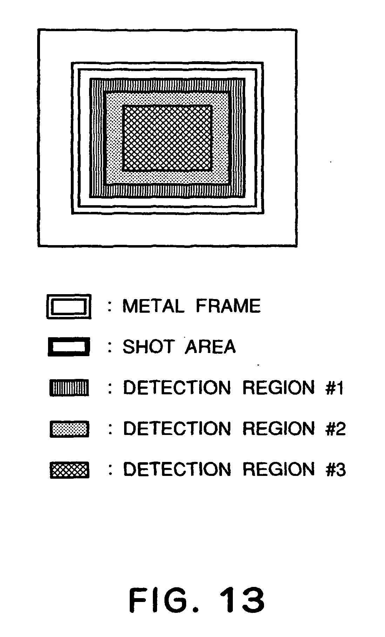

On the basis of the relationship described above, Figure 13 illustrates a detectable region depending on the incidence angle of detection light upon a pattern surface. Here, like Figure 6, three examples of incidence angles $\theta_{10}$, $\theta_{11}$ and $\theta_{12}$ ($\theta_{10}>\theta_{11}>\theta_{12}$) were set, and detectable regions in regard to these incidence angles were investigated. It is seen from Figure 13 that, with the incidence angle $\theta_{12}$ (smallest incidence angle), all the detection regions #1, #2 and #3 are detectable regions, and with the incidence angle $\theta_{11}$, the detection

regions #2 and #3 (about 80% of the shot region) are detectable regions. With the incidence angle $\theta_{10}$, only the detection region #3 (about 50% of the shot region) is a detectable region. Namely, it is seen that the incidence angle $\theta_{10}$ is too large and the detection points can be defined only in an area of about 50% of the shot region, such that a desired approximation surface precision (0.1 micron or less) is not attainable.

In summary, in order to estimate (approximate) the shape of a reticle pattern surface at a desired precision, the incidence angle of detection light upon the pattern surface should be not less than 45 deg. (where the reticle substrate is made of glass and a chromium pattern is formed on the glass substrate), and also the detection light should be projected on the reticle pattern surface with an incidence angle and an incidence direction which ensures that detection points are provided in a region of 80% or more of the shot region of the reticle.

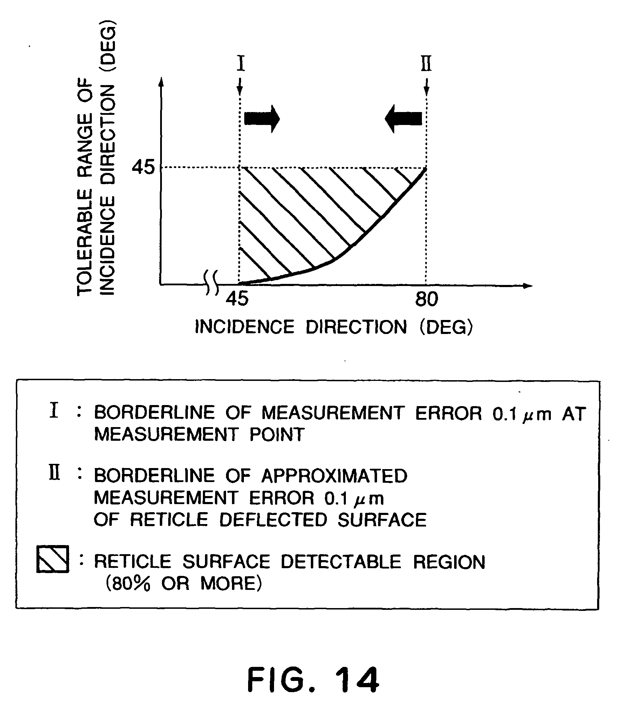

A simulation was carried out in regard to an example wherein $P_{xin}$ = 120 mm, $P_{yin}$ = 146 mm, $P_{xout}$ = 124 mm, $P_{yout}$ = 150 mm, $P_{xshot}$ = 108 mm, $P_{yshot}$ = 134 mm, h = 6.3 mm, and wherein the detectable region within the shot region was 80% or more. Figure 14 illustrates the results of simulation. Symbol I in the drawing refers to the condition for ensuring that the detection error at each detection point becomes equal to 0.1 micron or less. Symbol II refers to the condition for ensuring that 80% or more of the shot region becomes a detectable region. It is to be noted here that, since the results are linearly symmetrical with respect to a 45 deg. line of the incidence direction, those data in relation to the region more than 45 deg. incidence direction are omitted. It is seen from Figure 14 that, with an incidence angle not less than 45 deg. and not greater than 80 deg., an approximation surface of the pattern surface can be estimated with a desired precision. The range of incidence angle not less than 45 deg. and not greater than 80 deg. is applicable not only to a case where a pattern is formed by chromium on a glass substrate or a case where a metal frame or a short region is set with numerical values such as described above, but also to other various situations. As an example, the substrate of the reticle may not be glass, and the material for forming the pattern may not be chromium. Further, even if the height of the metal frame member, the size of the inside frame and the size of the shot region are different from the numerical values described above, in a case where a reticle with a metal frame (pellicle) is used, setting the incidence angle such as described above will still be preferable. This is also the case with the incidence direction $\varnothing$ of the detection light, as follows.

In a case where direct measurement can not be carried out throughout the whole shot region in relation to the measurement precision, the incidence direction $\varnothing$ of the detection light may be set at an angle not less than zero deg. and not greater than 90 deg. This enables direct measurement throughout the whole shot region with respect to the non-scan direction (detection region X = 108 to 120 mm, and Y = 107 to 108 mm), although in the scan direction the region in which direct measurement is unattainable becomes larger. With respect to this detection region, the number of detection points and the detection span may be set appropriately, to increase the precision of approximation measurement for the reticle surface shape.

Further, in a case where the above-described incidence direction ∅ (not less than zero deg. and not less than 90 deg.) is set, detection points may be provided in the shot region as well as a region inside the pellicle inner frame, in which no pattern is formed there.

Furthermore, the incidence direction of the detection light upon the pattern surface may be set so as to define, as viewed in a direction perpendicular to the pattern surface, an angle not less than 20 deg. and not greater than 70 deg. with respect to the scan direction. By doing so, the proportion of the detectable region inside the shot region becomes larger, such that the precision of the approximation surface can be improved more.

The surface position information as detected by means of the detecting system having features such as described above, is stored into the shape storing system 10. Then, on the basis of the thus stored surface position information, the operation unit 11 calculates, by approximation, the surface shape of the whole reticle surface. If during the calculation a surface shape that would lead to decreased exposure imaging performance is found, the flexure information with respect to the scan direction is supplied to the wafer stage, and correction is made so as to assure an appropriate focus driving amount during the scan exposure. Alternatively, if it is discriminated from the results of reticle surface shape measurement that the exposure imaging performance would be damaged thereby, the system has a function to supply a signal to the reticle stage RST from the control system 12 to urge replacement of reticles or resetting the reticle to the operator.

If it is possible from the standpoint of assembly, the number of detection points with regard to the non-scan direction is not limited to three, and one detection point or two detection points may be used. Also, four or more detection points may be set. Further, while in this embodiment the reticle substrate is made of glass which is coated with chromium to produce a pattern thereon, any other materials may be used for them.

As described above, the present invention can be applied to a scan type exposure apparatus (scanner) and an exposure apparatus called a stepper. Also, the invention is applicable to a device manufacturing method which includes a process of exposing a wafer by use of such an exposure apparatus and a developing process using a known mechanism.

In the surface position detecting system described above, polarized light may be used as the detection light to reduce the error of measurement of the reticle pattern surface. In that occasion, as described hereinbefore, the incidence angle and incidence direction of the detection light may be determined to make the measurement precision small.

Furthermore, in the embodiments described above (or corresponding exposure apparatuses), an alarm function may be provided so that: if it is clear, from the results of position detection at plural detection points and/or from the result of estimation of the pattern surface shape (position) based on the results of position detection at plural detection points, that during the actual exposure process the imaging performance would be necessarily damaged, reticle replacement or reticle resetting is urged or notified. This is very effective to prevent a decrease in yield, which might otherwise be caused by deterioration of the exposure performance due to the flexure of the reticle pattern surface or poor flatness thereof.

[INDUSTRIAL APPLICABILITY]

As described hereinbefore, according to the embodiments of surface position detecting method described above, the incidence angle measurement light is set to 45 deg to 80 deg. by which a detection error at each detection point attributable to a pattern formed on the reticle surface, can be well reduced (to 0.1 micron or less, for example). Also, if the detection light is concurrently projected in an oblique direction (with respect to the scan direction), the detection point setting region for setting detection points necessary for approximation measurement of the reticle surface shape can be widened with respect to both of the scan direction and the non-scan direction (up to 80% or more of the shot region). Thus, also the reticle surface approximation measurement error can be suppressed (to not greater than 0.1 micron). As a result, the surface shape information over the whole shot region to be exposed can be produced very precisely.

Furthermore, the results obtained by the reticle surface position detecting method such as described hereinbefore may be fed back to the wafer stage driving amount control, thereby to well attain a best focus and good distortion. A satisfactory imaging performance will be accomplished thereby. Further, if it is discriminated that the exposure imaging performance is degraded, since the system is provided with an alarm function for urging reticle replacement or reticle resetting, defect exposure due to any flexure or flatness change can be prevented effectively.

While the invention has been described with reference to the structures disclosed herein, it is not confined to the details set forth and this application is intended to cover such modifications or changes as may come within the purposes of the improvements or the scope of the following claims.

**Claims**

**1.** A scanning exposure apparatus, comprising

a projection optical system (PL) for projecting an image of a predetermined pattern formed on a reticle (R) onto a photosensitive substrate (W); and

a position detecting system for detecting positions, at different points on a surface of the reticle, with respect to a direction perpendicular to the reticle surface;

wherein said reticle includes a frame having a predetermined height with respect to the direction perpendicular to the reticle surface, and a dust adhesion preventing film; and

wherein said position detecting system includes a light projecting portion for directing light from a light source (5) to the reticle surface and a light receiving portion for receiving reflection light from the reticle surface;

**characterized in that**

the angle (θ) of incidence of light from said light projecting portion, being incident on the reticle surface, is not greater than 80 degrees, and

light from said light projecting portion is incident on the reticle surface while being obliquely inclined with respect to a scan direction of the reticle surface, as viewed in the direction perpendicular to the reticle surface.

2. A scanning exposure apparatus according to claim 1, wherein the angle (θ) of incidence of light from said light projecting portion, being incident on the reticle surface, is not less than 45 degrees.

3. A scanning exposure apparatus according to claim 1, wherein the light from said light projecting portion is incident on the reticle surface while being obliquely inclined with respect to a direction parallel to the frame, as viewed in the direction perpendicular to the reticle surface.

4. A scanning exposure apparatus according to claim 1, wherein, when viewed from a direction substantially perpendicular to the reticle surface, the light from said light projecting portion defines an angle (φ) not less than 20 deg. and not greater than 70 deg. with respect to the scan direction.

5. A scanning exposure apparatus according to claim 1, further comprising alarm means for notifying replacement of a reticle and/or resetting of the reticle on the basis of the detection with said position detecting system.

6. A device manufacturing method, comprising the steps of:

exposing a substrate by use of a scanning exposure apparatus as recited in claims 1 to 5; and developing the exposed substrate.

**Patentansprüche**

1. Abtastbelichtungsvorrichtung, mit
einem optischen Projektionssystem (PL) zum Projizieren eines Bildes eines vorbestimmten Musters, das auf einem Retikel (R) geformt ist, auf ein fotoempfindliches Substrat (W); und
einem Positionserfassungssystem zum Erfassen von Positionen an unterschiedlichen Punkten auf einer Oberfläche des Retikels, mit Bezug auf eine Richtung senkrecht zu der Retikeloberfläche;
wobei das Retikel einen Rahmen mit einer vorbestimmten Höhe mit Bezug auf die Richtung senkrecht zu der Retikeloberfläche und einem Film, der ein Haften von Schmutz verhindert, umfasst; und
wobei das Positionserfassungssystem einen Lichtprojektionsabschnitt zum Richten von Licht von einer Lichtquelle (5) auf die Retikeloberfläche und einen Lichtempfangsabschnitt zum Empfangen von reflektiertem Licht von der Retikeloberfläche umfasst;
**dadurch gekennzeichnet, dass**
der Einfallswinkel (θ) von Licht von dem Lichtprojektionsabschnitt, das auf die Retikeloberfläche einfällt, nicht größer als 80° ist, und
Licht von dem Lichtprojektionsabschnitt auf die Retikeloberfläche einfällt, während diese mit Bezug auf eine Abtastrichtung der Retikeloberfläche von der Richtung senkrecht zu der Retikeloberfläche aus gesehen schräg geneigt ist.

2. Abtastbelichtungsvorrichtung gemäß Anspruch 1, wobei der Einfallswinkel (θ) von Licht von dem Lichtprojektionsabschnitt, das auf die Retikelnoberfläche einfällt, nicht kleiner als 45° ist.

3. Abtastbelichtungsvorrichtung gemäß Anspruch 1, wobei das Licht von dem Lichtprojektionsabschnitt auf die Retikeloberfläche einfällt, während diese mit Bezug auf eine Richtung parallel zu dem Rahmen von der Richtung senkrecht zu der Retikeloberfläche aus gesehen schräg geneigt ist.

4. Abtastbelichtungsvorrichtung gemäß Anspruch 1, wobei, wenn von einer Richtung im Wesentlichen senkrecht zu der Retikeloberfläche aus gesehen, das Licht von dem Lichtprojektionsabschnitt einen Winkel (Φ) definiert, der mit Bezug auf die Abtastrichtung nicht kleiner als 20° und nicht größer als 70° ist.

5. Abtastbelichtungsvorrichtung gemäß Anspruch 1, weiterhin mit einer Warneinrichtung zum Mitteilen eines Austauschens eines Retikels und/oder Zurücksetzens des Retikels auf der Grundlage der Erfassung mit dem Positionserfassungssystem.

6. Gerätherstellungsverfahren, mit den Schritten:

Belichten eines Substrats unter Verwendung einer Abtastbelichtungsvorrichtung gemäß den Ansprüchen 1 bis 5; und
Entwickeln des belichteten Substrats.

## Revendications

1. Appareil d'exposition à balayage, comportant un système optique de projection (PL) destiné à projeter une image d'un motif prédéterminé formé sur un réticule (R) sur un substrat photosensible (W) ; et un système de détection de position destiné à détecter des positions, en différents points sur une surface du réticule, par rapport à une direction perpendiculaire à la surface du réticule ;
dans lequel ledit réticule comprend un cadre ayant une hauteur prédéterminée par rapport à la direction perpendiculaire à la surface du réticule, et un film empêchant l'adhérence de la poussière ; et
dans lequel ledit système de détection de position comprend une partie de projection de lumière destinée à diriger de la lumière depuis une source de lumière (5) sur la surface du réticule et une partie de réception de lumière destinée à recevoir de la lumière de réflexion provenant de la surface du réticule ;
**caractérisé en ce que**
l'angle ($\theta$) d'incidence de la lumière provenant de ladite partie de projection de lumière, qui est incidente sur la surface du réticule, n'est pas supérieur à 80 degrés, et
de la lumière provenant de ladite partie de projection de lumière tombe sur la surface du réticule tout en étant inclinée obliquement par rapport à une direction de balayage de la surface du réticule, comme vu dans la direction perpendiculaire à la surface du réticule.

2. Appareil d'exposition à balayage selon la revendication 1, dans lequel l'angle ($\theta$) d'incidence de la lumière provenant de ladite partie de projection de lumière, qui est incidente sur la surface du réticule, n'est pas inférieur à 45 degrés.

3. Appareil d'exposition à balayage selon la revendication 1, dans lequel la lumière provenant de ladite partie de projection de lumière tombe sur la surface du réticule tout en étant inclinée obliquement par rapport à une direction parallèle au cadre, comme vue dans la direction perpendiculaire à la surface du réticule.

4. Appareil d'exposition à balayage selon la revendication 1, dans lequel, lorsqu'elle est vue depuis une direction sensiblement perpendiculaire à la surface du réticule, la lumière provenant de ladite partie de projection de lumière définit un angle ($\theta$) qui n'est pas inférieur à 20 degrés ni supérieur à 70 degrés par rapport à la direction de balayage.

5. Appareil d'exposition à balayage selon la revendication 1, comportant en outre un moyen d'alarme destiné à notifier le remplacement d'un réticule et/ou la remise à l'état initial du réticule sur la base de la détection par ledit système de détection de position.

6. Procédé de fabrication de dispositif, comprenant les étapes qui consistent :

à exposer un substrat en utilisant un appareil d'exposition à balayage selon les revendications 1 à 5 ; et
à développer le substrat exposé.

LIGHT SOURCE

FIG. 1

FIG. 2

RETICLE

FIG. 3A    FIG. 3B    FIG. 3C

GRAVITY CENTER SHIFT

RETICLE PATTERN AREA

GLASS

FIG. 4

FIG. 5

FIG. 6

☐ : METAL FRAME

☐ : SHOT AREA

▦ : DETECTION REGION #1

▨ : DETECTION REGION #2

▩ : DETECTION REGION #3

FIG. 7

DETECTION LIGHT INCIDENCE
DIRECTION (DETECTION PLANE)

FIG. 8

DETECTION LIGHT

# FIG. 9

FIG. 10A

FIG. 10B

FIG. 10C

## FIG. 11

## FIG. 12

☐ : METAL FRAME

☐ : SHOT AREA

▦ : DETECTION REGION #1

▦ : DETECTION REGION #2

▦ : DETECTION REGION #3

# FIG. 13

I : BORDERLINE OF MEASUREMENT ERROR 0.1 μm AT
      MEASUREMENT POINT

II : BORDERLINE OF APPROXIMATED
       MEASUREMENT ERROR 0.1 μm
       OF RETICLE DEFLECTED SURFACE

▨ : RETICLE SURFACE DETECTABLE REGION
       (80% OR MORE)

FIG. 14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11045846 A
- US 20010028446 A